# EUROPEAN PATENT APPLICATION

(11) **EP 4 827 244 A1**
(43) Date of publication of application: **21.10.2026**
(21) Application number: 25305575.0
(22) Date of filing: 18.04.2025
(51) Int. Cl.: H05H 1/24, H01J 37/32, H01J 37/34, C23C 14/34, C23C 14/35

(54) **SPUTTERING PROCESS FOR GENERATION OF CHARGED PARTICLES BEAM**

(71) Applicant: Centre National de la Recherche Scientifique, 75016 Paris (FR); Université de Lorraine, 54000 Nancy (FR); Université d'Orléans, 45100 Orléans (FR)
(72) Inventor: CUYNET, Stéphane, Nancy (FR); JEAN-MARIE DESIREE, Ronny, Laxou (FR); DE POUCQUES, Ludovic, Nancy (FR); CAILLARD, Amaël, Clery Saint André (FR)
(74) Representative: Office Freylinger

(57) **Abstract**

The invention relates to a sputtering process for generating a charged particles beam (40), whereby an **E** x **B** crossed field is applied to a sputtering target (20) in a vacuum environment, wherein the sputtering target (20) includes a hollow tube-shaped sputtering target (22) extending along a longitudinal axis in which a plasma phase is generated, the target having at least one open end (24, 24').

At least over a predetermined length of the hollow tube-shaped sputtering target (22):
- an electric field **E** is generated inside (27) the hollow tube-shaped sputtering target (22), the electric field gradient being uniform in the vicinity of the sputtering target and normal thereto; and
- a first magnetic field **B** is generated inside (27) the hollow tube-shaped sputtering target (22);

According to the invention, the first magnetic field **B** is generated by means of a first magnet arrangement (30) positioned outside the target (20) and configured to uniformly generate, along said predetermined length, a magnetic field gradient of **B** whose component **Bₜ** is orthoradial to the longitudinal axis,
whereby a first unidirectional **E** x **B** drift is obtained along the longitudinal axis that induces a linear erosion of the inner surface of the sputtering target along the longitudinal axis as well as an unidirectional and anisotropic linear drift motion of charged particles along the longitudinal axis such that a charged particles beam (40) exits at the open end (24) of the target (20).

The invention also relates to a corresponding sputtering device and is suitable in sputtering deposition processes but also in other applications, e.g. implantation, isotopic separation, etching and propulsion.

## Description

### FIELD OF THE INVENTION

The present invention generally relates to the sputtering of target materials by physical routes, and more specifically to a magnetron sputtering process designed especially to generate charged particles beams.

### BACKGROUND OF THE INVENTION

Plasma sputtering processes are generally used to produce thin films of very high purity and high quality, and has developed considerably in recent years. Plasma sputtering is a process in which energetic ions from a plasma collide with a solid target body, causing atoms or molecules to be ejected from its surface. In other words, the erosion of the target body in plasma sputtering occurs due to the interaction with the ionized gas, in the plasma state. The interaction between the plasma and the surface of the target produces a sheath through which gas ions will be accelerated to impact the target to be sputtered, causing the ejection of the target atoms.

Improved plasma sputtering systems incorporate a set of magnets to form a magnetron, which enhances ionization efficiency of the gas at low pressure and plasma confinement. Such systems and corresponding processes are referred to as magnetron sputtering.

The magnets, usually positioned beneath the target body, generate a magnetostatic field that interacts with charged particles in the chamber. The electrons emitted by the cathode (target body) are accelerated by the electric field formed by the potential difference but are also deflected by the magnetic field of the magnetron. The combination of these two fields confines the electrons near the target, increasing their probability of colliding with atoms and causing ionization, particularly when the magnetic field is perpendicular to the electric field.

A key phenomenon in magnetron sputtering is the **E** x **B** drift, where electrons move perpendicularly to both the electric and magnetic fields. This drift is essential in sustaining the plasma and influencing the trajectory of sputtered particles. However, in conventional magnetron sputtering systems, the **E** x **B** drift often follows a closed-loop path, leading to non-uniform target erosion and inefficient material utilization. Additionally, the uneven wear pattern on the target results in premature replacement, increasing operational costs and material waste.

The primary application of magnetron sputtering is thin-film deposition, widely used in industries such as semiconductor manufacturing, optics, and coatings. This process enables the precise fabrication of conductive, insulating, or protective layers on various substrates.

Another application of magnetron sputtering is the exploitation of the sputtered material itself, which can be ionized within the plasma to generate a directional ion beam. Indeed, magnetron sputtering may also be used for ion beam generation, as disclosed e.g. in WO 2019/125186 A1. In this context, the generated ion beam consists predominantly of ions derived from the sputtered target material, rather than from the plasmogenous process gas.

Whatever the use of magnetron sputtering process and system, limitations are the same, namely non-uniform target erosion and inefficient material utilization.

### OBJECT OF THE INVENTION

It is thus an object of the invention to provide an improved charged particles beam generation process by sputtering technique.

### SUMMARY OF THE INVENTION

In order to achieve the above-mentioned object, the present invention proposes a sputtering process for generating a charged particles beam, whereby an **E** x **B** crossed field is applied to a sputtering target (cathode) in a vacuum environment, wherein the sputtering target includes a hollow tube-shaped sputtering target extending along a longitudinal axis, the target having at least one open end;
wherein at least over a predetermined length of the hollow tube-shaped sputtering target:
an electric field **E** is generated inside the hollow tube-shaped sputtering target, the electric field gradient being uniform in the vicinity of the sputtering target and normal thereto; and
a first magnetic field **B** is generated inside the hollow tube-shaped sputtering target.

According to the present invention, the first magnetic field **B** is generated by means of a first magnet arrangement positioned outside the target and configured to uniformly generate, along said predetermined length, a magnetic field gradient of **B** whose component **Bt** is orthoradial to the longitudinal axis (such that magnetic field lines perpendicular to the longitudinal axis are generated);
whereby a first unidirectional **E** x **B** drift is obtained along the longitudinal axis, that induces a linear erosion of the inner surface of the sputtering target along the longitudinal axis as well as an unidirectional and anisotropic linear drift motion of charged particles along the longitudinal axis such that a charged particles beam exits at the open end of the target.

In other words, a unidirectional **E** x **B** drift during a plasma phase is generated/sustained inside the tubular target, whereby a beam of charged particles (ionized sputtered species) is obtained and spontaneously flows toward the open end of the target, with or without the addition of a voltage bias.

The electric field **E** is uniform in the vicinity of the target, meaning it is consistent near the target where it produces effects thereon. This uniformity ensures consistent electrical effects on the target surface. The electric field **E** is perpendicular to the inner surface of the hollow cathode.

The magnetic field **B** is generated uniformly at least over the predetermined length. As a result, the magnetic field presents the same strength or characteristics at a given distance from the inner surface of the sputtering target along the predetermined length. In other words, in any cross-section (perpendicular to the longitudinal axis) of the sputtering target along the longitudinal axis within the predetermined length, magnetic field lines are the same.

As will be understood from the following, each magnet arrangement generates a magnetic field that is effective substantially along the length of magnet arrangement, but only on a sector (portion of the circumference/periphery) of the cathode. The magnet arrangement is configured to generate a substantially uniform magnetic field along the longitudinal axis.

As used herein, the term uniform or uniformly, as used with respect to the generation of the magnetic field or electric field, means that the generating means are distributed in a substantially uniform manner along the axis, such that the properties of the magnetic or electric field are the same along the predetermined length, or any variation along the axis remains within a tolerance range of no more than 10%, preferably below 5%.

Thanks to the specific geometry of their magnetron, the inventors found that uniformly generated electric field **E** and magnetic field **B** (over the predetermined length of the cathode) resulted in an anisotropic linear drift motion during any plasma discharge. Consequently, the electron density is also non-isotropic under these conditions (under such **E** x **B** drift). The anisotropic linear drift motion is supported by the generation and confinement of an anisotropic plasma in the vicinity of the inner surface of the sputtering target.

The inhomogeneity or anisotropy of the linear drift motion results in a plasma gradient thereof along the longitudinal axis, which in turn results in a flow of charged particles toward the open end of the sputtering target.

Moreover, the anisotropy of the linear drift motion results in the erosion of a first racetrack (or erosion track) on the inner surface of the sputtering target, with a depth of the erosion track (or racetrack) that increases towards one of the open ends of the hollow tube-shaped sputtering target (dictated by the direction of the crossed field vector).

The process can be continued until the erosion track traverses the thickness of the tubular cathode (i.e. full sputtering). Due to drift anisotropy, a higher erosion speed is observed on the exit side of the tubular target.

Rotating the target or the magnet arrangement(s) around the longitudinal axis allows to fully (i.e. completely) consume -that is to say sputter- the end of the sputtering target, without loss of non-sputtered material as compared to conventional processes. Accordingly, means may be provided to apply a relative rotation motion, around the longitudinal axis, between the cathode and the magnet arrangement(s). Such means may be arranged to either effect a rotation of the cathode around its longitudinal axis relative to the magnet arrangement(s) or effect a rotation of the magnet arrangement(s) around the longitudinal axis of the cathode, relative to the cathode/target.

Furthermore, in embodiments the target may be translated along the longitudinal axis to further increase the consumption of material of the sputtering target. Alternatively, the target may be fixed and the magnet arrangement(s) may be translated along the longitudinal axis. Here, means are provided to operate a relative translation motion between the cathode and the magnet arrangement(s) along the longitudinal axis.

By combining rotation and translation of the hollow tube-shaped sputtering target and/or magnet arrangements, it becomes possible to fully sputter the target material, aiming at no (or very minimal) waste of sputtering material.

The present invention is not limited to cylindrical sputtering targets. Indeed, the cross-section of the hollow tube-shaped sputtering target may present any geometry, in particular it may be circular, ovoid, oval, or polygonal (such as e.g. square, rectangular, or hexagonal).

In embodiments, at least one further magnetic field is generated by means of a further magnet arrangement positioned outside the target and configured to uniformly generate, along said predetermined length, further magnetic field gradient of **B** whose respective component **Bₜ** is orthoradial to the longitudinal axis; whereby a further unidirectional **E** x **B** drift is obtained along the longitudinal axis, that induces an unidirectional and anisotropic linear drift motion of charged particles along the longitudinal axis. This generates an additional directional stream of charged particles that contributes to the flow of charged particles that flow toward the cathode's open end and exit therethrough.

So, there can be a plurality of further magnet arrangements, each arranged along a respective portion of the cathode periphery, each generating a respective unidirectional **E** x **B** drift along the longitudinal axis, that induces a flow of charged particles towards the tube open end.

Such embodiment with two magnet arrangements (or more) advantageously enhances material utilization efficiency as sputtered elements from one erosion track (or racetrack) contribute to sustaining the plasma of the opposite erosion track, thereby reducing dependence on external gas ionization, improving deposition consistency. It is currently believed that such embodiment will allow to achieve a self-sputtering process.

In general, a conventional plasma process (or regime) may be operated to ignite a plasma and sustain the sputtering of target species in the cathode. The plasma is generally controlled by applying a bias voltage to the cathode that is above the breakdown conditions. In the context of the invention, the plasma is generated, at least in the initial phase. In the context of the invention, the generation of the plasma may imply that a plasma is initiated, sustained, and may also extinguish and be subsequently re-ignited. The plasma process may be of any kind, such as being selected from a direct current (DC) magnetron sputtering process, a pulsed direct current (DC) magnetron sputtering process, a high-power impulse magnetron sputtering process, or a combination thereof.

In particular embodiments, at least one transitory, electron accelerating pulse is applied to the sputtering target after plasma ignition to enhance ionization, whereby applying said electron accelerating pulse involves applying a high negative bias voltage to the sputtering target during a period of time shorter than 1 microsecond, the bias voltage having an absolute value greater than 1 kV.

Such electrons accelerating pulses enable an increase of the number of ions resulting from the species/atoms sputtered from the target material with respect to non-ionized atoms sputtered from the target material. Indeed, accelerated electrons on a fast rise time hit species/atoms sputtered from the target material and present in the reactor, thereby ionizing the species/atoms and forming ionized species, or ions. Thenceforth, the energy and directionality of the ions may advantageously be controlled by applying a bias directly to the sputtering target (e.g. thanks to bi-polar regime).

Remarkably, such electron accelerating pulses enable to significantly improve the ionization rate of the sputtered material (i.e. the number of ionized atoms sputtered from the target material with respect to non-ionized, neutral sputtered atoms) without requiring any additional device to be inserted into the reactor. This is of particular relevance as such additional devices (e.g. additional coils or magnets) are generally very disruptive and often cumbersome with respect to the sputtering process, such as but without being limited to a coating/deposition process. Additionally, it is currently believed that the electron accelerating pulses may, under certain operating conditions, allow controlling the degree of ionization of the sputtered species.

According to some other embodiments, the sputtering process comprises performing sequences of electron accelerating pulses, the sequences being configured to generate a plasma, sustain the sputtering of target species and accelerate electrons, whereby applying an electron accelerating pulse involves applying a high negative bias voltage to the sputtering target during a period of time shorter than 1 microsecond, the bias voltage having an absolute value greater than 1 kV.

In other words, bursts of electron accelerating pulses are applied to the target and will generate the plasma and subsequently provide the electron acceleration effect described above.

In embodiments, the sputtering process further comprises applying a bias voltage to the sputtering target configured to forcibly extract the charged particles beam. Directionality and transport efficiency of the sputtered ions are advantageously increased.

The sputtering target may comprise one or more materials, e.g. any metal or compound, in particular metals, metallic alloys, metal hydrides, metal nitrides, metal oxides, polymers or combinations thereof.

In embodiments, the target material is selected from the post-transition and transition metals groups notably comprising tungsten, aluminium, copper, nickel, titanium, platinum, palladium, silver and gold, their respective alloys, their respective hydrides, their respective oxides, their respective nitrides and the mixtures thereof. Carbon and some alkaline earth metals and metalloids as magnesium, calcium, boron and silicon are also considered as target material.

Any appropriate plasmogenous process gas (or plasmogenous gas, or plasma-generating gas) may be employed, e.g. selected from reactive and inert gases. The plasmogenous process gas may be pure or mixed.

In embodiments, the plasmogenous process gas is selected from the group comprising helium, neon, argon, krypton, xenon, hydrogen, nitrogen, oxygen, and mixtures thereof.

Benefits of the inventive sputtering process may be summarized as follows:
- Implementation of one or more linear anisotropic **E** x **B** drift motion(s) which enables:
   o the complete sputtering of a hollow tube-shaped sputtering target through the addition of actuating means allowing rotation and translation of the target relative to the magnet arrangement(s).
   ∘ the establishment of self-sputtering conditions by utilizing highly energetic discharge regimes such as application of electron accelerating pulses.
   ∘ the generation of one or more charged particles beams directed toward the open end of the hollow tube-shaped sputtering target.
   ∘ the generation of beams of charged particles of any kind, allowing the sputtering of all elements of the periodic table and their isotopes.
   ∘ low energy consumption, comparable to that of a conventional magnetron system.
- high adaptability and simple implementation of the invention process, making it compatible with various conventional plasma generating processes.
- extremely clean process, potentially eliminating the need for additional plasmogenous gas.
- cost efficiency, with no additional costs relating to energy consumption, beyond the initial investment in the magnetron sputtering system.

Another merit of the invention is that it may be implemented in numerous possible application fields, as it is independent of the target material to be sputtered as well as of the (inert or reactive) plasmogenous gas. The invention finds particular application in sputtering deposition processes, especially in combination with conventional sputtering deposition processes, as well as implantation, isotopic separation, etching and propulsion, e.g. spatial propulsion.

According to a second aspect, the invention also relates to a sputtering device for generating a charged particles beam in a low-pressure environment, comprising a sputtering target including a hollow-tube shaped sputtering target extending along a longitudinal axis, the target having at least one open end, a power supply and a first magnet arrangement.

The power supply is configured to generate, at least over a predetermined length of the sputtering target, an electric field **E** inside the hollow tube-shaped sputtering target, the electric field being uniform in the vicinity of the sputtering target and normal thereto.

In other words, the electric field is uniformly distributed over the predetermined length and normal to the sputtering target inner surface.

According to the invention, the magnet arrangement is positioned outside the sputtering target and is configured to uniformly generate, along said predetermined length, a magnetic field gradient of **B** whose component **Bt** is orthoradial to the longitudinal axis, such that an unidirectional **E** x **B** drift is obtained along the longitudinal axis, that induces an unidirectional and anisotropic linear drift motion of charged particles along the longitudinal axis such that a beam of charged particles exits at one open end of the target. In other words, a charged particles beam is generated and can be extracted from the said open end of the target, with or without the addition of bias.

What was said above regarding the inventive sputtering process applies mutatis mutandis to the charged particles beam generating device of the second aspect.

Such device is advantageously configured for performing the sputtering process according to the first aspect. Indeed, the power supply being configured to generate an electric field normal to the inner surface of the hollow tube-shaped sputtering target and the magnet arrangement being configured to uniformly generate magnetic field lines in a plane perpendicular to the longitudinal axis, the resulting **E** x **B** drift is unidirectional along the longitudinal axis and induces an anisotropic linear drift motion of electrons and ions along the longitudinal axis such that a beam of charged particles is produced at said open end of the target.

In embodiments, the device comprises more than one magnet arrangement, each magnet arrangement being configured as the first magnet arrangement, and the magnet arrangement are distributed (preferably regularly albeit non-regular spacing of magnet arrangements is also part of the present invention) around the circumference (outer periphery) of the sputtering target.

Preferably, the charged particles beam generating device further comprises a second magnet arrangement positioned outside the target and being configured to uniformly generate, along the predetermined length, a further magnetic field gradient of **B** whose component **Bt** is orthoradial to the longitudinal axis (resulting in further uniform magnetic field lines perpendicular to the longitudinal axis).

According to the same or other embodiments, the device may comprise actuating means configured to rotate the sputtering target around the longitudinal axis and/or may comprise actuating means configured to translate the sputtering target along the longitudinal axis. Alternatively or additionally, the device may comprise actuating means configured to rotate the magnet arrangement(s) around the longitudinal axis and/or may comprise actuating means configured to translate the magnet arrangement(s) along the longitudinal axis.

Such actuating means allow to perform a relative movement (rotation and/or translation) between the sputtering target and magnet arrangement(s) upon utilization, thereby uniformly eroding the target material and increasing consumption of the sputtering target, hence also reducing material waste.

In embodiments, the sputtering device comprises a source of plasmogenous gas, that may be used to at least initiate a plasma discharge.

In the present text, low pressure means a pressure of no more than 100 Pa, preferably less than 10 Pa, more preferably less than 1 Pa.

In embodiments the sputtering device may comprise a low-pressure chamber (or vacuum chamber), the sputtering target being arranged inside the chamber.

According to yet another aspect, the present invention also relates to the use of a sputtering device according to the second aspect in any one of a physical deposition process, an isotopic separation process, an etching process, an implantation process, a propulsion process, such as e.g. for spatial propulsion.

In yet another aspect, the present invention also relates to a spatial propulsion device comprising the sputtering device of the second aspect, or being configured to implement the sputtering process according to the first aspect.

### BRIEF DESCRIBTION OF THE DRAWINGS

The present invention will now be described, by way of example, with reference to the accompanying drawings, in which:
FIG.1 is a principle cross-sectional view of an embodiment of a sputtering device according to the invention;
FIG.2 is a principle longitudinal cross-sectional view through the sputtering device of FIG.1, where the principle of the inventive process is illustrated;
FIG.3 is a schematic view of two magnet arrangements according to the present invention;
FIG.4 is a picture (side view) of a prototype of a device according to the invention generating an anisotropic beam of charged particles; and
FIG.5 are principle views of the sputtering target of FIG.1 during use showing erosion tracks.

### DETAILED DESCRIPTION OF PREFERRED EMBODIMENTS

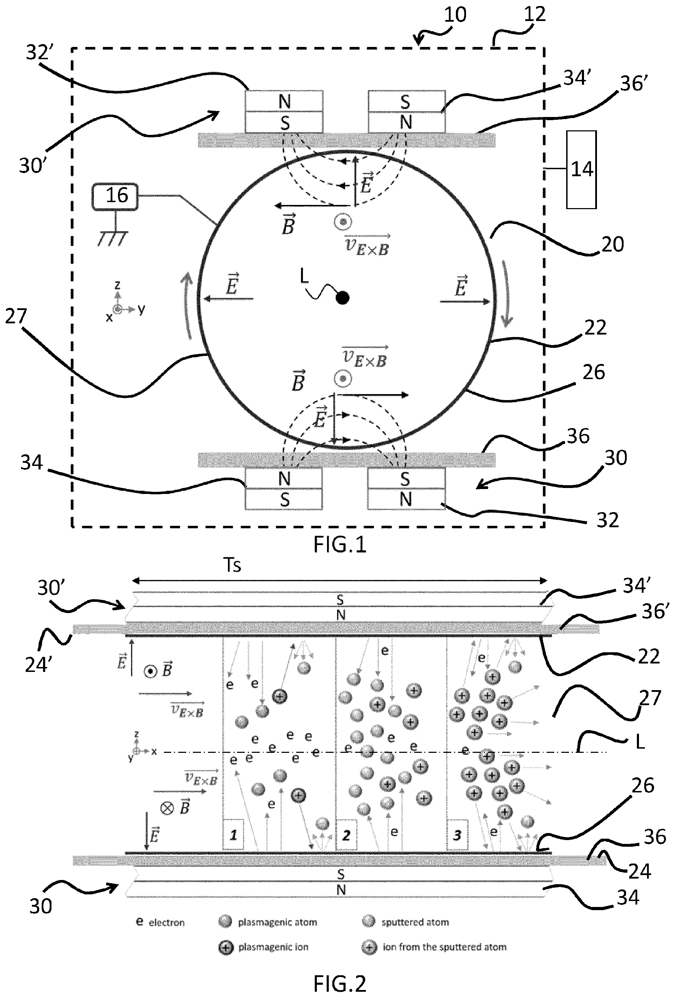

An embodiment of a device according to the present invention, as well as the related sputtering process, is described below with reference to FIG.1 (radial cross-section) and FIG.2 (longitudinal cross-section).

The present sputtering device 10 comprises a vacuum chamber schematically indicated 12, connected to a source of plasmogenous gas 14 that may be used to at least initiate a plasma discharge. The device further comprises a sputtering target 20 that includes a hollow tube-shaped sputtering target 22 extending along a longitudinal axis L with at least one open end 24 (i.e. at least a portion of the sputtering target 20 is shaped as a hollow tube 22 with an open end 24).

The sputtering target of FIG.1 presents a circular cross-section perpendicularly to the longitudinal axis, i.e. the hollow tube-shaped sputtering target 22 is formed as a straight circular tube. It is open at both ends, indicated 24 and 24'. However, the cross-section may have any other shape such as e.g. an ovoid or polygonal (square, rectangular, hexagonal...) shape. In the following, the hollow tube-shaped sputtering target 22 is simply referred to as target or tubular target.

In the embodiment of FIG.1 and 2, the sputtering target 20 extends in the direction of axis X (i.e. the longitudinal axis L is along the X direction), while the circular cross-section is in a plane YZ.

The device 10 also comprises a power supply 16 connected to the tubular target 22 (acting as cathode), which is configured to generate over a predetermined section length Ts of the sputtering target an electric field E. E is generated inside the sputtering target 20 to be normal to an inner surface 26 thereof.

The power supply 16 is connected to apply a voltage bias to the tubular target 22 that induces the electric field E and may be used to generate the plasma (voltage bias is above the breakdown conditions), as discussed below.

The electric field E is uniform in the vicinity of the inner surface 26 of the target 22 (i.e. near the surface target, where the surface 26 of the target 22 will be eroded / sputtered by the sputtering process). More specifically, a uniform electric field gradient is obtained.

As will be understood, the term 'predetermined length' (or 'predetermined section') refers to the fact that the process is performed such that a given length of the target is treated (i.e. along axis L). The predetermined length is indicated Ts in the figures such as in FIG.2.

The device 10 further comprises at least one magnet arrangement 30, 30'. In the shown embodiment, as visible from FIG.1, it comprises two distinct magnet arrangements 30, 30' arranged diametrically opposed around the circumference of the (cross section of the) sputtering target 22. The magnet arrangements 30, 30' extend over the length of the predetermined length Ts. A support 36, 36' made from dielectric material may be arranged between the magnets 32, 34, 32', 34' of the magnet arrangement 30, 30' and the sputtering target 20.

Each magnet arrangement 30, 30' is positioned outside the sputtering target 20 and uniformly generates, over the predetermined length Ts, magnetic fields lines that are perpendicular to the longitudinal axis, see FIG.1. The magnetic field lines are in a plane normal to the longitudinal axis. More specifically, each magnet arrangement is distributed uniformly along the axis L and length Ts, to ensure a homogenous/uniform generation of magnetic field. A magnetic field gradient of **B** with a component **Bₜ** orthoradial to the longitudinal axis is obtained. **Bt** is illustrated (as **B)** in FIG.2. As will be understood, the **Bt** component is maximal mid-way between the two poles, with **Bt** being substantially equal to **B.**

Each magnet arrangement 30, 30' comprises two magnet sets 32, 34; 32', 34' positioned along the longitudinal direction, with opposite poles facing the cylindrical wall of the target 22, generating field lines flowing in the same direction (here clockwise). The magnets 32, 34, 32', 34' may be permanent magnets or electro-magnets.

Each magnet arrangement 30, 30' generates a local magnetic field that extends over the length Ts, but only over a portion of the periphery (angular section).

As will be understood by those skilled in the art, although the generation of the magnetic field **B** is uniform, side effects may exist at the axial ends of the magnet arrangements 30, 30', such as e.g. variability of the magnetic field / magnetic field lines. These are however considered negligible over the length of the magnet arrangements 30, 30'.

The magnetic field generation is uniform in the sense that it is symmetrical and homogeneous over the length - along the longitudinal axis - of the predetermined length Ts. In other words, on a given radial position, at a given distance from the inner surface 26 of the target 22, the magnetic field is the same, whatever the longitudinal position along the predetermined length Ts. So by abuse of language, the magnetic field B can thus be qualified as "uniform" along the predetermined length.

Due to the respective orientation of the electric **E** and magnetic **B** fields, unidirectional **E x B** drifts are obtained along the longitudinal axis. This is achieved for each magnet arrangement, whereby one erosion track is produced per magnet arrangement.

As visible on FIG.1, the electric field being always oriented toward the inner surface 26 of the sputtering target 20 (perpendicular thereto), the magnet arrangements 30, 30' are configured to generate respective magnetic fields **B** that are oriented such that the resulting **E** x B drifts will have the same orientation. As discussed above, this is obtained by keeping the same arrangement of polarities at any angular position of the magnet arrangement 30, 30'.

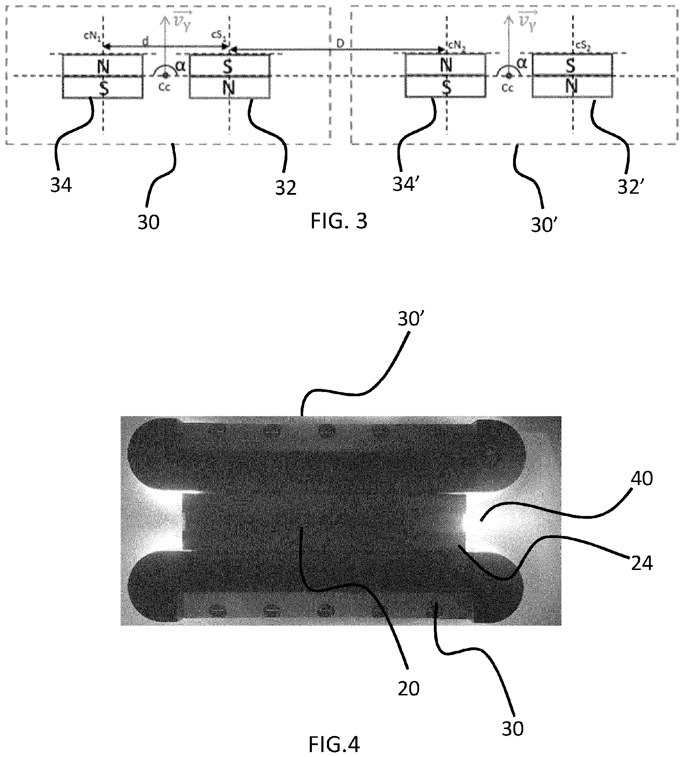

During plasma discharge, the **E** x **B** drifts induce an anisotropic linear drift motion of ions/charged particles along the longitudinal axis such that a beam of charged particles 40 is discharged at the open end 24 of the sputtering target 20 (see FIG.2 and detailed explanation thereof below, and FIG. 4).

While the embodiment of FIG.1 discloses two magnet arrangements 30, 30', the present inventive process and device for charged particle generation may comprise any number (at least equal to one) of magnet arrangements 30, 30', such as e.g. one, two, three or more magnet arrangements. One magnet arrangement 30 configured in accordance with the present disclosure is enough to generate an ion/charged particle beam. When there is more than one magnet arrangement 30, 30', the number thereof does not need to be even.

Relative positioning (i.e. arrangement) of the two magnet arrangements 30, 30' is further explained with reference to FIG.3, wherein:
- cNx and cSx are the respective centers of the magnetic fluxes at the surfaces of the magnets forming a given magnet arrangement x (i.e. either the first or second magnet arrangement);
- d is the distance separating cNx and cSx for a given magnet arrangement x;
- α is the angle at the center of symmetry Cc of a respective magnet arrangement and corresponds to the inclination of the two magnets forming the magnet arrangement with respect to each other;
- *ν*γ is the vector originating from Cc and being directed towards the center of symmetry of the cross-section of the sputtering target;
- D is the distance separating the magnet arrangements around the sputtering target;
- k is the total number of magnet arrangements surrounding the sputtering target (k = 2 in the embodiment of FIG.1);
- P is the external perimeter of the cross-section of the sputtering target.

In embodiments, to obtain unidirectional, linear **E** x **B** drift motions, the following conditions are met:
- 150° *< α* < 210°
- d is chosen such that *Bt* > 0.05 *T*
- *D* > 1.30 * *d*
- *k* _{*} (*d + D*) > *P*

With d necessarily implying that *Bt* > 0.05 *T* , Bt being the maximal value of the magnetic field tangent to the inner surface of the sputtering target.

If there are more than two magnet arrangements 30, 30', the above relations must be satisfied for all magnet arrangements, considered two at a time.

In the shown example, at any point of the inner surface 26 of the sputtering target 20 of the device 10 of FIG.1, with the sputtering target 20 extending along axis L (i.e. parallel to axis X), the electric field **E** extends radially in the YZ plane and is thus perpendicular to the inner surface of the target. The component **Bt** of the magnetic field **B** is always orthoradial to axis X. The resulting **E x B** drift therefore extends in the direction of axis X, i.e. along the longitudinal axis L of the sputtering target 20. As indicated above, the component **Bt** is the strongest at the midpoint between the two opposite magnetic poles, where it will be perpendicular to the electric field **E** (due to the magnet configuration), resulting in a maximum **E** x **B** drift. This will define the position of the erosion track.

In practice, the magnetic field tends to generate a confined, elongate plasma sheath along the predetermined length, centered on the erosion track. The atoms sputtered from the target get ionized within the plasma, and are then subject to drift motion by the applied **E** x **B** cross field.

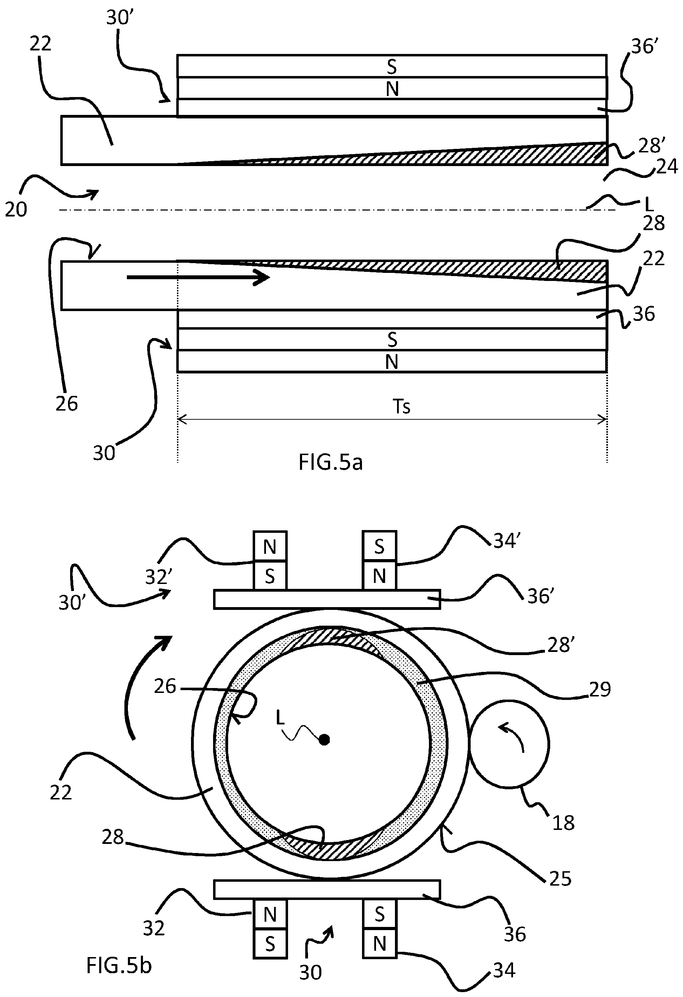

In the present embodiment, the device 10 enables the internal surface 26 (inner surface) of the sputtering target to be sputtered at two erosion tracks 28, 28'. These internal target's erosion tracks 28, 28' are thus produced where the **B** and **E** fields are orthogonal to each other (see FIG.5).

Due to the design of this embodiment, the two erosion tracks (racetracks) 28, 28' face each other. It should be noted that, there is no limit to the number of erosion tracks 28, 28' (determined by the number of magnet arrangements 30, 30'), nor is it necessary for this number to be even. Coupled with a magnetic field **B** of suitable topology inducing linear unidirectional **E** x **B** cross-field drift, the embodiment shown in FIG.1 implies that the sputtered species from each erosion zone (or erosion track 28, 28') are mutually self-supplying.

The sputtered species are intrinsically contained and partially trapped in the internal volume 27 of the tubular target 22. This configuration therefore intrinsically favors collisions with the electrons and hence the ionization mechanisms of the sputtered elements. Thus, the confinement of the electrons and the sputtered material within such tubular target 22 should mechanically make it possible to increase the partial pressure of the sputtered element and thus to eventually be able to do without any plasma-generating gases (e.g. Ar...) to maintain the plasma (continuous operation) and/or the pre-ionisation conditions of the discharge for frequency or pulsed plasmas.

The present charged particles beam generation process will now be explained with reference to FIG.2, which shows three steps or stages of the inventive process. The first step (step 1 on FIG.2) involves injecting energetic electrons into the volume 27 of the hollow sputtering target 22. In the tubular target, the electrons are both repelled by the electric field gradient and confined by the magnetic field lines. The electrons trapped in this way artificially increase the electric field gradient **E** and can therefore form a so-called 'virtual' electrode. This virtual electrode also forms an electrical junction with the system's reference potential, either directly due to charges leaking in the direction of this reference, or via an adhoc device enabling an additional electric field to be applied, co-linear with the **E** x **B** drift (resulting in forced extraction of the beam of charged particles by the application of a bias voltage). Independently on how the electrical junction is formed, this virtual electronic electrode makes it possible to electrically close the electrical circuit. In addition, the increase in the electric field also implies an equivalent increase in the velocity of the **E** x **B** drift motion, with an invariant magnetic field **B.** Ultimately, this first step ionizes the atoms of a plasmogenous gas of any kind introduced within the tubular target 22 and initiates sputtering of its inner surface 26.

The second step (step 2 on FIG.2) is conventional in sputtering processes, and consists of filling the volume close to the surface 26 of the hollow sputtering target 22 with atoms of the latter. Under erosion of the target in several zones 28, 28' and in a volume open only in the direction of the linear drift, the partial pressure of elements from the target increases sharply. In this way, the sputtered material at one of the erosion tracks 28 can be transported and will feed the ionization volume of the other erosion track 28', and vice versa. Coupled with the electron trapping mechanisms (due to the **E** and **B** fields being cross fields and resulting **E** x **B** drift), this mechanism of self-feeding sputtering target elements with vapor leads de facto to a significant improvement in the ionization of these elements and therefore in the plasma density.

The third step (step 3 on FIG.2) may or may not be concomitant with the second step, depending on the discharge. This last stage consists of ionizing the pulverized material to a very large extent in order to generate the desired ion beam (or more generally charged particles beam 40, considering also electrons). The architecture of the present sputtering device, which induces a (controlled, precise) arrangement of the **E** and **B** fields, makes it possible to generate such a beam 40 (FIG.4 showing a charged particles beam exiting the hollow tube-shaped sputtering target 22 at one open end thereof 24 - right end here).

The plasma itself may be generated in any appropriate manner, e.g. by operating any kind of plasma process, such as e.g. a direct current magnetron sputtering process, a pulsed direct current magnetron sputtering process, a high-power impulse magnetron sputtering process, or a combination thereof. However, a regime that maximizes ionization of the target sputtered elements is preferred, so that discharge process such as HiPIMS, with or without performing electron accelerating steps, are preferred.

Most preferably, the plasma process is as described in patent application PCT/EP2024/074613 and further comprises electron accelerating pulses, i.e. at least one transitory, electron accelerating pulse is applied to the sputtering target after plasma ignition to enhance ionization, whereby applying said electron accelerating pulse involves applying a high negative bias voltage to the sputtering target during a period of time shorter than 1 microsecond, the bias voltage having an absolute value greater than 1 kV.

Alternatively, plasma may be generated solely by performing sequences of electron accelerating pulses as defined above. The sequences will generate a plasma, sustain the sputtering of target species and accelerate electrons.

Visual observation of the device in operation clearly demonstrates the generation of charged particles beam 40 (FIG.4) that exits the tubular target 20 along its longitudinal axis at one open end 24. The directional charged particles beam 40 exiting the target 20 at the open end 24 is formed by the contribution of the charged particles issuing from the magnet arrangements 30, 30'. After a short period of use of the sputtering device, it is even possible to observe the impact of the linear **E x B** drift on the inner surface 26 of the hollow sputtering target 22.

Inhomogeneity of the **E x B** drift, with the electron density being higher where the **E** x **B** drift velocity is smaller and vice versa, results in a flow of charged species and thereby in erosion tracks (or racetracks) 28, 28' which deepens toward the aperture (open end 24) of the sputtering target 20 (FIG.5a). To optimize the consumption of the target material and achieve uniform erosion, the sputtering target 20 may undergo a rotation (see arrow in FIG.5b) around its central axis, i.e. the longitudinal axis (revolution axis of the sputtering target). Alternatively, the sputtering target may be fixed and the magnet arrangements 30, 30' may be rotated around the target 20 (around the longitudinal axis). This rotation ensures that the entire inner circumference of the sputtering target 20 is exposed to the plasma over time. As a result, the portions of the sputtering target directly facing the magnet arrangements are actively eroded (active erosion track 28, 28'), while the remaining part is on stand-by (stand-by erosion track 29), and will be actively eroded again once back in front of the magnet arrangements 30, 30', due to the relative rotation movement between magnet arrangement(s) 30, 30' and sputtering target 20.

By continuously rotating, the erosion caused by ion bombardment is distributed evenly across the inner circumference of the target, and terminal section of the sputtering target may be fully eroded / sputtered. Rotation means may comprise one or more rollers 18 applied to the outer surface 25 of tubular target 22, at least one roller being coupled to an electric motor (not shown).

Consumption of the sputtering target is further improved by translating the sputtering target 20 along its central axis (i.e. the longitudinal axis, see arrow in FIG.5a) or translating the magnet arrangements 30, 30' along said axis, which corresponds to the direction of the **E**x**B** drift.

These combined motions-rotation and translation-advantageously leads to an optimum and complete erosion of the sputtering target 20 during the sputtering process / generation of charged particles beam.

## Claims

1. A sputtering process for generating a charged particles beam (40), whereby an **E x B** crossed field is applied to a sputtering target (20) in a vacuum environment, wherein the sputtering target (20) includes a hollow tube-shaped sputtering target (22) extending along a longitudinal axis in which a plasma phase is generated, the target having at least one open end (24, 24'); wherein at least over a predetermined length of the hollow tube-shaped sputtering target (22):
- an electric field **E** is generated inside (27) the hollow tube-shaped sputtering target (22), the electric field gradient being uniform in the vicinity of the sputtering target and normal thereto; and
- a first magnetic field **B** is generated inside (27) the hollow tube-shaped sputtering target (22);
**characterized in that** said first magnetic field **B** is generated by means of a first magnet arrangement (30) positioned outside the target (20) and configured to uniformly generate, along said predetermined length, a magnetic field gradient of **B** whose component **Bt** is orthoradial to the longitudinal axis,
whereby a first unidirectional **E x B** drift is obtained along the longitudinal axis that induces a linear erosion of the inner surface of the sputtering target along the longitudinal axis as well as an unidirectional and anisotropic linear drift motion of charged particles along the longitudinal axis such that a charged particles beam (40) exits at the open end (24) of the target (20).

2. The sputtering process of claim 1, wherein the first **E x B** drift erodes a first racetrack (28) on the inner surface (26) of the sputtering target (20) with a depth that increases continuously towards one of the open ends (24) of the hollow tube-shaped sputtering target (22).

3. The sputtering process of claim 1 or 2, wherein at least one further magnetic field is generated by means of a further magnet arrangement (30') positioned outside the target (20) and configured to uniformly generate, along said predetermined length, a further magnetic field gradient of **B** whose respective component **Bt** is orthoradial to the longitudinal axis;
whereby a further unidirectional **E** x **B** drift is obtained along the longitudinal axis, that induces a linear erosion of the inner surface of the sputtering target along the longitudinal axis as well as an unidirectional and anisotropic linear drift motion of charged particles along the longitudinal axis.

4. The sputtering process according to any one of the preceding claims, wherein the sputtering target (20) and the magnet arrangement(s) (30, 30') is/are rotated relative to one another around the longitudinal axis.

5. The sputtering process according to any one of the preceding claims, wherein the sputtering target (20) and the magnet arrangement(s) (30, 30') is/are translated relative to one another along the longitudinal axis.

6. The sputtering process according to any one of the preceding claims, wherein a plasma process is operated to ignite a plasma and sustain the sputtering of target species, preferably wherein the plasma process is selected from a direct current (DC) magnetron sputtering process, a pulsed direct current (DC) magnetron sputtering process, a high-power impulse magnetron sputtering process, or a combination thereof.

7. The sputtering process according to claim 6, wherein at least one transitory, electron accelerating pulse is applied to the sputtering target after plasma ignition to enhance ionization, whereby applying said electron accelerating pulse involves applying a high negative bias voltage to the sputtering target during a period of time shorter than 1 microsecond, the bias voltage having an absolute value greater than 1 kV.

8. The sputtering process according any one of claims 1 to 5, comprising performing sequences of electron accelerating pulses, the sequences being configured to generate a plasma, sustain the sputtering of target species and accelerate electrons, whereby applying an electron accelerating pulse involves applying a high negative bias voltage to the sputtering target during a period of time shorter than 1 microsecond, the bias voltage having an absolute value greater than 1 kV.

9. The sputtering process according to any one of the preceding claims, further comprising applying a bias voltage to the sputtering target (20) configured to promote extraction of the charged particles beam (40).

10. A sputtering device (10) for generating a charged particle beam (40) in a low-pressure environment, comprising a sputtering target (20) including a hollow-tube shaped sputtering target (22) extending along a longitudinal axis, the target having at least one open end (24, 24'), a power supply (16) and a first magnet arrangement (30);
wherein the power supply (16) is configured to generate, at least over a predetermined length of the sputtering target, an electric field E inside (27) the hollow tube-shaped sputtering target (22), the electric field gradient being uniform in the vicinity of the sputtering target and normal thereto; and
**characterized in that** the first magnet arrangement (30) is positioned outside the target (20) and configured to uniformly generate, along said predetermined length, a magnetic field gradient of **B** whose component **Bt** is orthoradial to the longitudinal axis, such that an unidirectional **E** x **B** drift is obtained along the longitudinal axis, that induces a linear erosion of the inner surface of the sputtering target along the longitudinal axis as well as an unidirectional and anisotropic linear drift motion of charged particles along the longitudinal axis such that a charged particles beam (40) exits at one open end (24) of the target.

11. The sputtering device (10) of claim 10, further comprising one or more further magnet arrangement (30') positioned outside the target (20) and being configured to generate uniformly, along the predetermined length, further magnetic field lines perpendicular to the longitudinal axis.

12. The sputtering device (10) of claim 10 or 11, further comprising actuating means configured to rotate the sputtering target around the longitudinal axis and/or comprising actuating means configured to translate the sputtering target along the longitudinal axis.

13. The sputtering device (10) of claim 10, 11 or 12, further comprising a source of plasmogenous gas (14).

14. Use of a sputtering device as claimed in any one of claims 10 to 13 in any one of a physical deposition process, an isotopic separation process, an etching process, an implantation process, a propulsion process.

15. A satellite propulsion device comprising a sputtering device as claimed in any one of claims 10 to 13.
